# EUROPEAN PATENT APPLICATION

(11) **EP 4 800 598 A1**
(43) Date of publication of application: **02.09.2026**
(21) Application number: 26154530.5
(22) Date of filing: 27.01.2026
(51) Int. Cl.: G06F 30/18, G05B 19/418, G06F 30/20

(54) **LIGHTWEIGHT INDUSTRIAL SIMULATOR**

(30) Priority: 27.02.2025 US 202519065952
(71) Applicant: Hitachi, Ltd., Tokyo 100-8280 (JP)
(72) Inventor: Kato, Takumi, Tokyo, 100-8280 (JP); Zhi Li, Hu, Tokyo, 100-8280 (JP)
(74) Representative: Mewburn Ellis LLP

(57) **Abstract**

A method for performing system simulations that comprises receiving, by a processor, input data for generating a simulation model; generating, by the processor, the simulation model for performing simulations based on the input data, the simulation model comprises a voxel model that performs simulations as voxel-by-voxel representations; and generating, by the processor, a simulation report based on simulation output of the simulation model.

## Description

### BACKGROUND

### Field

The present disclosure is generally directed to methods and systems for performing system simulations.

### Related Art

Designing and improving industrial systems, such as distribution centers and factories, involves several decision-making processes with limited information. The processes are largely dependent on the expert's experience and simple calculation tools like spreadsheets. However, some of the important in-depth analyses are qualitatively impossible with conventional spreadsheets. The lack of understanding of the current design can lead to an inefficient system that is difficult to resolve later.

In the related art, a method for performing industrial system simulations through simulation models is disclosed. While simulations may be performed to deepen the understanding of target industrial system operations/designs, the associated modeling cost has proven to be too costly and economically unfeasible.

In the related art, a method for performing industrial system simulations through lightweight simulation models is disclosed. However, such simulation models are not complex/sophisticated enough to gain deep understanding of the current industrial system operations/designs.

There exists a need for a method and a system that is capable of performing accurate industrial system simulations while keeping modeling costs reasonable.

### SUMMARY

Aspects of the present disclosure involve an innovative method for performing system simulations. The method may include receiving, by a processor, input data for generating a simulation model; generating, by the processor, the simulation model for performing simulations based on the input data, the simulation model comprises a voxel model that performs simulations as voxel-by-voxel representations; and generating, by the processor, a simulation report based on simulation output of the simulation model.

In some example implementations, each of the voxel-by-voxel representations comprise one or more agents and one or more receptors in voxel form across a plurality of grids.

In some example implementations, the simulations are performed by: performing model simulation initialization; and performing event simulations.

In some example implementations, performing the model simulation initialization comprises: loading the input data; and initializing a simulation timer and an event list, wherein the input data comprises system layout data, assembly order information, and inventory data.

In some example implementations, performing the event simulations comprises: generating events to be added to the event list based on the input data and adding the events to the event list; and performing the event simulations based on the events contained in the event list.

In some example implementations, generating the events to be added to the event list comprises: verifying parts required for performing one or more assemblies contained in the assembly order information by cross-referencing the inventory data; and generating a transportation order for each of the one or more assemblies where parts required have been successfully verified.

In some example implementations, the method may further include generating, by the processor, one or more transportation events that correspond to one or more transportation order; generating, by the processor, one or more assembly events that correspond to one or more assemblies where parts required have been successfully verified; and adding, by the processor, the one or more transportation events and the one or more assembly events to the event list.

In some example implementations, performing the event simulations comprises: extracting the one or more transportation events and the one or more assembly events from the event list; and performing simulations based on the one or more transportation events and the one or more assembly events.

In some example implementations, the method may further include identifying, by the processor, a simulation termination condition for stopping the simulations; determining, by the processor, whether the simulation termination condition has been satisfied; for the simulation termination condition being determined as satisfied, terminating, by the processor, the simulations; and for the simulation termination condition not determined as satisfied, continuing, by the processor, the simulations until the simulation termination condition is met.

In some example implementations, the simulation report comprises a voxel-based visualization and a plurality of Key Performing Indicators (KPI) derived based on the simulations.

Aspects of the present disclosure involve an innovative system for performing system simulations. The system may include a data storage; and a processor in communication with the data storage, wherein the processor is configured to: receive input data for generating a simulation model and storing the input data in the data storage; generate the simulation model for performing simulations based on the input data, the simulation model comprises a voxel model that performs simulations as voxel-by-voxel representations; and generate a simulation report based on simulation output of the simulation model.

In some example implementations, each of the voxel-by-voxel representations comprises one or more agents and one or more receptors in voxel form across a plurality of grids.

In some example implementations, the simulations are performed by: performing model simulation initialization; and performing event simulations.

In some example implementations, performing the model simulation initialization comprises: loading the input data; and initializing a simulation timer and an event list, wherein the input data comprises system layout data, assembly order information, and inventory data.

In some example implementations, performing the event simulations comprises: generating events to be added to the event list based on the input data and adding the events to the event list; and performing the event simulations based on the events contained in the event list.

In some example implementations, generating the events to be added to the event list comprises: verifying parts required for performing one or more assemblies contained in the assembly order information by cross-referencing the inventory data; and generating a transportation order for each of the one or more assemblies where parts required have been successfully verified.

In some example implementations, the processor is further configured to: generate one or more transportation events that correspond to one or more transportation order; generate one or more assembly events that correspond to one or more assemblies where parts required have been successfully verified; and add the one or more transportation events and the one or more assembly events to the event list.

In some example implementations, performing the event simulations comprises: extracting the one or more transportation events and the one or more assembly events from the event list; and performing simulations based on the one or more transportation events and the one or more assembly events.

In some example implementations, the processor is further configured to: identify a simulation termination condition for stopping the simulations; determine whether the simulation termination condition has been satisfied; for the simulation termination condition being determined as satisfied, terminate the simulations; and for the simulation termination condition not determined as satisfied, continue to perform the simulations until the simulation termination condition is met.

In some example implementations, the simulation report comprises a voxel-based visualization and a plurality of Key Performing Indicators (KPI) derived based on the simulations.

Aspects of the present disclosure involve an innovative non-transitory computer readable medium, storing instructions for performing system simulations. The instructions may include receiving input data for generating a simulation model; generating the simulation model for performing simulations based on the input data, the simulation model comprises a voxel model that performs simulations as voxel-by-voxel representations; and generating a simulation report based on simulation output of the simulation model.

In some example implementations, each of the voxel-by-voxel representations comprises one or more agents and one or more receptors in voxel form across a plurality of grids.

In some example implementations, the simulations are performed by: performing model simulation initialization; and performing event simulations.

In some example implementations, performing the model simulation initialization comprises: loading the input data; and initializing a simulation timer and an event list, wherein the input data comprises system layout data, assembly order information, and inventory data.

In some example implementations, performing the event simulations comprises: generating events to be added to the event list based on the input data and adding the events to the event list; and performing the event simulations based on the events contained in the event list.

In some example implementations, generating the events to be added to the event list comprises: verifying parts required for performing one or more assemblies contained in the assembly order information by cross-referencing the inventory data; and generating a transportation order for each of the one or more assemblies where parts required have been successfully verified.

In some example implementations, the instructions may further include generating one or more transportation events that correspond to one or more transportation order; generating one or more assembly events that correspond to one or more assemblies where parts required have been successfully verified; and adding the one or more transportation events and the one or more assembly events to the event list.

In some example implementations, performing the event simulations comprises: extracting the one or more transportation events and the one or more assembly events from the event list; and performing simulations based on the one or more transportation events and the one or more assembly events.

In some example implementations, the instructions may further include identifying a simulation termination condition for stopping the simulations; determining whether the simulation termination condition has been satisfied; for the simulation termination condition being determined as satisfied, terminating the simulations; and for the simulation termination condition not determined as satisfied, continuing the simulations until the simulation termination condition is met.

In some example implementations, the simulation report comprises a voxel-based visualization and a plurality of Key Performing Indicators (KPI) derived based on the simulations.

### BRIEF DESCRIPTION OF DRAWINGS

A general architecture that implements the various features of the disclosure will now be described with reference to the drawings. The drawings and the associated descriptions are provided to illustrate example implementations of the disclosure and not to limit the scope of the disclosure. Throughout the drawings, reference numbers are reused to indicate correspondence between referenced elements.
FIG. 1 illustrates an example system architecture of a simulator 100 for performing industrial system simulations, in accordance with an example implementation.
FIG. 2 illustrates an example voxel-based model simulation 200 as generated by the simulator 100, in accordance with an example implementation.
FIG. 3 illustrates an example process flow 300 for performing model simulations, in accordance with an example implementation.
FIG. 4 illustrates an example process flow 400 for performing initialization function 120, in accordance with an example implementation.
FIG. 5 illustrates an example process flow 500 for performing timing function 150, in accordance with an example implementation.
FIG. 6 illustrates an example process flow 600 for performing event function 170, in accordance with an example implementation.
FIG. 7 illustrates an example process flow 700 for performing self-order generation function 180, in accordance with an example implementation.
FIG. 8 illustrates an example process flow 800 for performing simulation termination determination, in accordance with an example implementation.
FIG. 9 illustrates an alternate process flow 900 for performing simulation termination determination, in accordance with an example implementation.
FIG. 10 illustrates an example process flow 1000 for performing report generation, in accordance with an example implementation.
FIG. 11 illustrates an example output 1100 of calculated agents' activity rates, in accordance with an example implementation.
FIG. 12 illustrates an example output 1200 of the report generator 195, in accordance with an example implementation.
FIG. 13 illustrates example transportation orders 130b, in accordance with an example implementation.
FIG. 14 illustrates example transportation orders 130b, in accordance with an example implementation.
FIG. 15 illustrates example assembly orders 130c, in accordance with an example implementation.
FIG. 16 illustrates example layout data 130a, in accordance with an example implementation.
FIG. 17 illustrates an example computing environment with an example computer device suitable for use in some example implementations.

### DETAILED DESCRIPTION

The following detailed description provides details of the figures and example implementations of the present application. Reference numerals and descriptions of redundant elements between figures are omitted for clarity. Terms used throughout the description are provided as examples and are not intended to be limiting. For example, the use of the term "automatic" may involve fully automatic or semi-automatic implementations involving user or administrator control over certain aspects of the implementation, depending on the desired implementation of one of the ordinary skills in the art practicing implementations of the present application. Selection can be conducted by a user through a user interface or other input means, or can be implemented through a desired algorithm. Example implementations as described herein can be utilized either singularly or in combination, and the functionality of the example implementations can be implemented through any means according to the desired implementations.

Present example implementations relate to methods and systems for performing system simulations that are accurate and cost-efficient. The goal is to strike a balance between modeling cost and the accuracy of the models. For example, mitigating modeling cost while maintaining the accuracy of the simulation results by mainly focusing on compromising the aesthetic and complexity of visualization, enhancing simulation results' accuracy, and the functionality of incorporating business data. Example implementations allow users to limit the component options, which makes the modeling process easier to understand and allows modeling to be expanded based on the specific needs of the use case.

By computing the simulation space as a voxel-by-voxel representation instead of a continuous space representation, which typically induces more computation to calculate the trajectories of agents and visualize the trajectory of agents, computational complexity can be drastically reduced. Furthermore, by eliminating/removing the modeling aesthetic and task allocation/management, wastage of resources (e.g., data processing, bandwidth, behavior modeling representation, etc.) and costs can be further reduced.

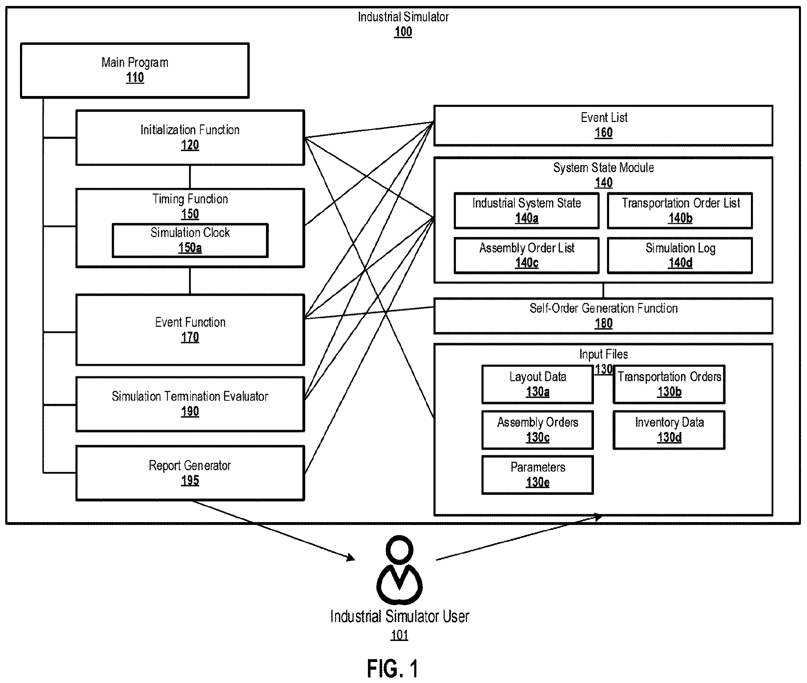

FIG. 1 illustrates an example system architecture of a simulator 100 for performing industrial system simulations, in accordance with an example implementation. The simulator 100 may be a lightweight industrial simulator that simulates the transportation and assembly from upstream to the downstream production processes in an industrial system.

The simulator 100 may include components such as, but not limited to, a main program 110, an initialization function 120, a system state module 140, a timing function 150, an event list 160, an event function 170, a self-order generation function 180, a simulation termination evaluator 190, a report generator 195, etc. The simulator 100 is a lightweight discrete event simulator that generates events and processes the generated events. In addition, the simulator 100 also performs calculation of Key Performance Indicators (KPIs) to measure and improve system performance.

As illustrated in FIG. 1, the simulator 100 may be accessed by a user 101 to perform system simulations. The user 101 (e.g., one or more users/operators, etc.) prepares and enters the input data into the simulator 100, which is converted into input files 130. The simulator 100 then generates output data/report from the report generator 195 based on the input files 130, and provides the generated output to the user 101 for review.

Input files 130 may include information such as, but not limited to, layout data 130a, transportation orders 130b, assembly orders 130c, inventory data 130d, parameters 130e, etc. In some example implementations, the main program 110 comprises one or more Artificial Intelligence (Al)/Machine Learning (ML) model for converting received input data into input files 130.

The ML/AI model may include, but not limited to, one or more of convolutional neural network (CNN), recurrent neural network (RNN), deep RNN (DRNN), Q-learning network (QN), deep Q-learning network (DQN), linear regression, decision trees, K-Nearest Neighbors, etc. RNN may include long short-term memory (LSTM), large language model (LLM), etc. The ML/AI model may be (i) received externally from a server after the model has been trained; or (ii) generated and trained locally. The ML/AI model may be trained using historical system data and voxel diagrams.

In some example implementations, the ML/AI model may be a generative AI model. The generative AI model may utilize any one or combination of a variety of different models in generating the input files 130, including but not limited to, generative adversarial networks (GANs), variational auto-encoders (VAEs), auto-regressive models, transformers, etc. The AI module is iteratively trained using historical data as training input, and training parameters are adjusted to generate optimal input data to be used in performing model simulations.

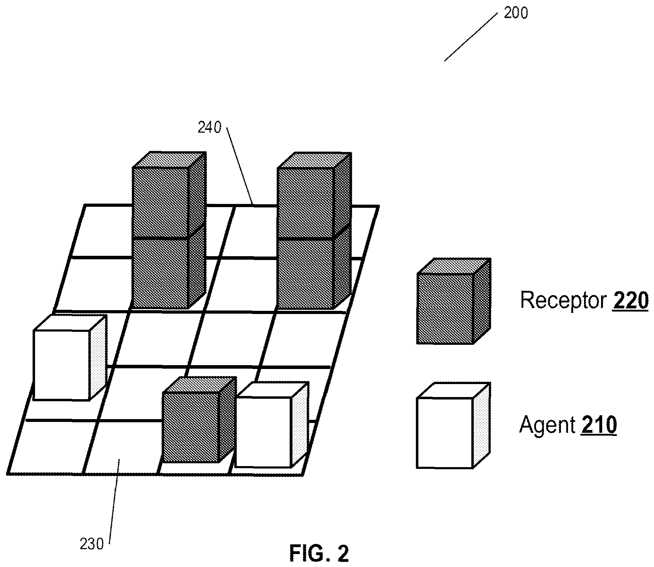

The layout data 130a comprises basic system information/component information as derived from the input data. Specifically, the layout data 130a may include one or more agents, one or more receptors, and facility layout information. FIG. 2 illustrates an example voxel-based model simulation 200 as generated by the simulator 100, in accordance with an example implementation. As illustrated in FIG. 2, the voxel-based diagram 200 may include components such as, but not limited to, agents 210, receptors 220, grids 230, etc. The agents 210, the receptors 220, and the grids 230 correspond to the agents, the receptors, and the facility layout as contained in layout data 130a.

The grids 230 together form a floor 240 in the simulation space. Each grid 230 has its corresponding coordinates in the floor 240. Receptors 220 are objects that perform the function of stocking/storing items or inventories (e.g., parts, sub-assembly of parts, products, tools, boxes for storing parts, etc.) inside the facility. For example, each receptor 220 may be a shelf, a bin, a station, or any other area/space capable of stocking/storing items included in the inventory data 130d. Inventory data 130d define where inventories/items are located at the various receptors 220. One or more receptors 220 may be placed in a grid 230 based on the facility layout. A number of receptors 220 may be stacked and placed within a grid 230.

Agents 210 represent objects that perform the functions of (i) transporting/moving items or inventories from one receptor 220 to the next; and (ii) assembling the items/inventories being transported at a destination receptor 220. The agents 210 only move from one grid to the next, and not within a grid. Parameters 130e provide information needed to simulate the actions of the agents 210 in performing model simulations.

Referring back to FIG. 1, the system state module 140 contains industrial system state 140a, transportation order list 140b, assembly order list 140c, and a simulation log 140d. The layout data 130a, the inventory data 130d, and the parameters 130e may be stored in the industrial system state 140a of the system state module 140 for access and processing. The transportation orders 130b may be stored in the transportation order list 140b for access and processing. The assembly orders 130c are stored in the assembly order list 140c. The assembly orders 130c comprise structured data that define parts that make up components of products or sub-components to other components. In some example implementations, the assembly orders 130c may comprise tree-structured data that provide association information between assemblies and receptors.

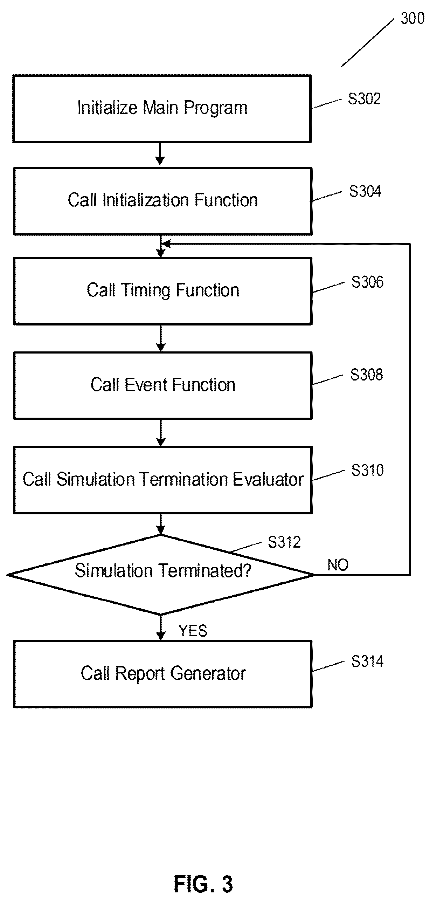

FIG. 3 illustrates an example process flow 300 for performing model simulations, in accordance with an example implementation. As illustrated in FIG. 3, the process begins at step S302 where the main program 110 is initiated. At step S304, the main program calls the initialization function 120. The initialization loads the input files 130 and initializes the timing function 150 and the event list 160. The process then continues to step S306, wherein the timing function is performed, and calls the event function 170 at step S308 to perform event generation and event processing.

At step S310, the simulation termination evaluator 190 is called to determine whether to terminate the current simulation session, and a determination is made at step S312 to see whether simulation has been terminated. If the answer is yes at step S312, then the process continues to step S314 where the report generator is called to generate a simulation report/summary. If the answer is no at step S312, then the process returns to step S306 to continue with the simulation session.

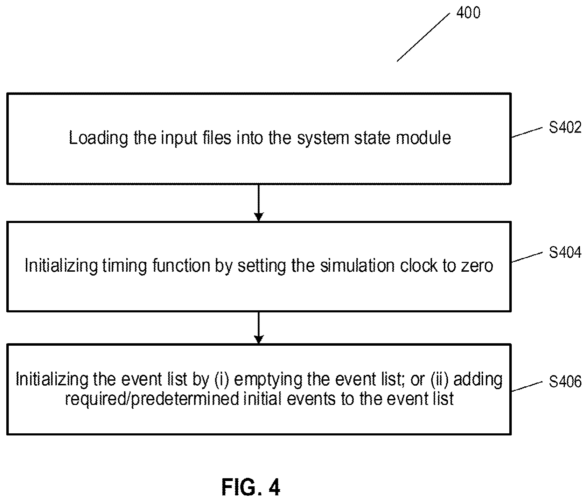

FIG. 4 illustrates an example process flow 400 for performing initialization function 120, in accordance with an example implementation. The process flow 400 is triggered when the initialization function 120 is called by the main program 110 at step S304. The process begins by loading the input files 130 into the system state module 140 at step S402. At step S404, the timing function 150 is initialized. Specifically, initialization is performed by setting a simulation clock 150a of the timing function 150 to zero. At step S406, the event list 160 is initialized by (i) emptying the event list 160; or (ii) adding required/predetermined initial events to the event list 160. The event list 160 comprises a listing of two types of events: transportation events and assembly events.

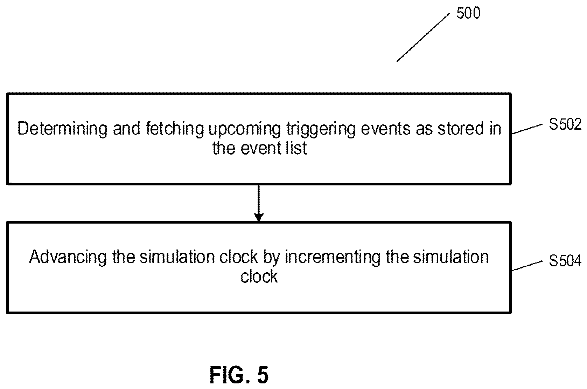

FIG. 5 illustrates an example process flow 500 for performing timing function 150, in accordance with an example implementation. The process flow 500 is triggered when the timing function 150 is called by the main program 110 at step S306. The process begins by determining and fetching upcoming triggering events as stored in the event list 160 and passing the events to the event function 170 at S502. At step S504, the simulation clock 150a of the timing function 150 is advanced. Specifically, the simulation clock 150a is incremented by a specified time interval/predetermined time period associated with the fetched event(s) (e.g., estimated time for performing the listed event(s)).

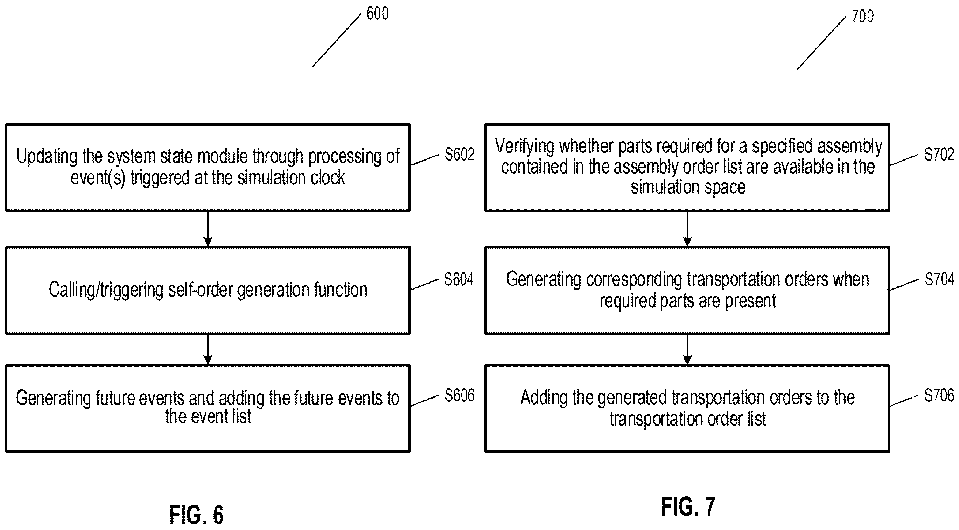

FIG. 6 illustrates an example process flow 600 for performing event function 170, in accordance with an example implementation. The process flow 600 is triggered when the event function 170 is called by the main program 110 at step S308. The process begins by updating the system state module 140 through processing of event(s) triggered at the simulation clock 150a at step S602. Industrial system state is updated based on the simulation/processing results of the event(s), and reflecting/storing the processing results in the simulation log 140d.

There are two types of events: transportation events and assembly events. By processing the transportation events, the items/inventories are transported by the agent(s) from a source receptor to a destination receptor. By processing the assembly events, the items/inventories at a receptor are combined/assembled into a new component and stored in the receptor.

The process then continues to step S604 where the self-order generation function 180 is called/triggered. FIG. 7 illustrates an example process flow 700 for performing self-order generation function 180, in accordance with an example implementation. The process flow 700 is triggered when the self-order generation function 180 is called by the event function 170 at step S604. The process begins at step S702 where a verification process is performed to verify whether parts required for a specified assembly contained in the assembly order list 140c are available in the simulation space. For example, whether such parts can be located in the industrial system state 140a.

If the required parts are present, the corresponding transportation orders are then generated at step S704. The generated transportation orders are then added to the transportation order list 140b at step S706. Referring back to FIG. 6, at step S606, generated future events (generated future transportation events/orders and future assembly events/orders) are then added to the event list 160 for subsequent retrieval and processing.

In some example implementations, the main program 110 comprises one or more Artificial Intelligence (AI)/Machine Learning (ML) model for performing simulation optimization. The AI/ML model may be used to perform one or more of agent optimization, receptor optimization, and route optimization.

Agent optimization: the AI/ML model may be used to optimize the number of agents on the floor. In the industrial setting, there may be a number of processes being performed in an industrial system. Allocating an appropriate number of workers in each process is crucial in ensuring that the system operates efficiently in terms of productivity and cost. Reinforcement learning may be used to explore the optimal number of agents to be used in each process.

Receptor optimization: the AI/ML model may be used to optimize the number of receptors on the floor. In the industrial setting, there may be a number of storage areas and buffer spaces in between processes. Since space is limited in industrial systems, it is important to have a proper number of storage spaces, equipment, or space on the floor to keep the operation efficient. Reinforcement learning may be used to explore the optimal number of receptors to be used in each process.

Route optimization: the AI/ML model may be used to perform path optimization. If Automated Guided Vehicles (AGVs) are being utilized in an industrial system, it is important to optimize the routes of the AGVs to avoid route conflicts, which may cause delays in transportation of items/inventories and product assemblies. AGVs may include Autonomous Mobile Robots (AMRs), forklifts, or any other autonomous entities capable of making path decisions autonomously. Specifically, those that make AGVs wait for other agents to move, etc. Reinforcement learning may be utilized to explore path-planning decisions and find the best path-finding policy to maximize the overall performance of the industrial system.

The AI/ML model can generate simulation results using different numbers of agents, receptors, and agent path-finding policies. With agent optimization, a number of agents can be provided to generate performance values that are then converted into a reward value. With receptor optimization, a number of receptors can be provided to generate performance values that are then converted into a reward value. With route optimization, a number of AGVs can be provided to generate performance values that are then converted into a reward value. The collected reward values can then be used to optimize the function in the reinforced learning agent. In some example implementations, the data acquisition and training processes may occur simultaneously.

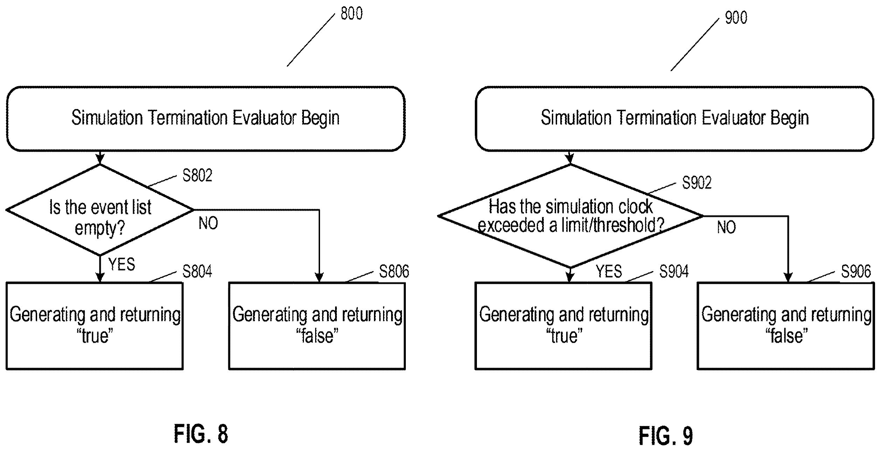

FIG. 8 illustrates an example process flow 800 for performing simulation termination determination, in accordance with an example implementation. The process flow 800 is triggered when the simulation termination evaluator 190 is called by the main program 110 at step S310. The process begins at step S802 where a determination is made as to whether the event list 160 is empty. Specifically, whether events as contained in the event list 160 have all been processed. If the answer is yes at step S802, then "true" is generated and returned to the main program 110 at step S804. If the answer is no at step S802, then "false" is generated and returned to the main program 110 at step S806.

FIG. 9 illustrates an alternate process flow 900 for performing simulation termination determination, in accordance with an example implementation. The process flow 900 is triggered when the simulation termination evaluator 190 is called by the main program 110 at step S310. The process begins at step S902 where a determination is made as to whether the simulation clock 150a exceeds a predetermined limit/threshold. In some example implementations, the threshold may be a predetermined operation threshold (e.g., business hours, etc.). If the answer is yes at step S902, then "true" is generated and returned to the main program 110 at step S904. If the answer is no at step S902, then "false" is generated and returned to the main program 110 at step S906.

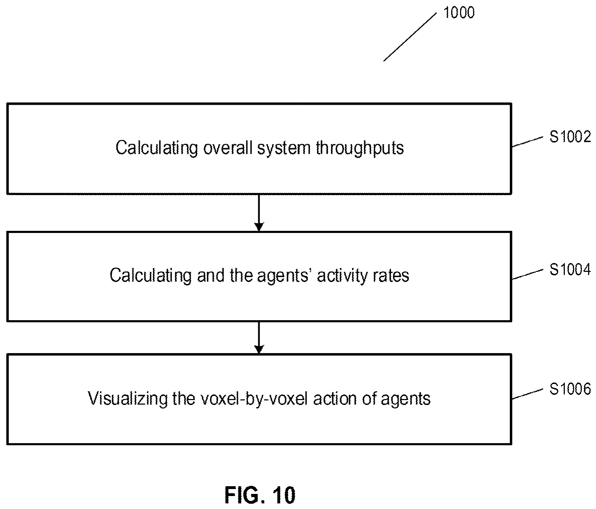

FIG. 10 illustrates an example process flow 1000 for performing report generation, in accordance with an example implementation. The process flow 1000 is triggered when the report generator 195 is called by the main program 110 at step S310. The process begins at step S1002 where overall system throughputs are calculated as simulations are performed. In some example implementation, the calculated system throughputs comprise Key Performance Indicators (KPIs) of the system. At step S1004, agents' activity rates calculated as simulations are performed.

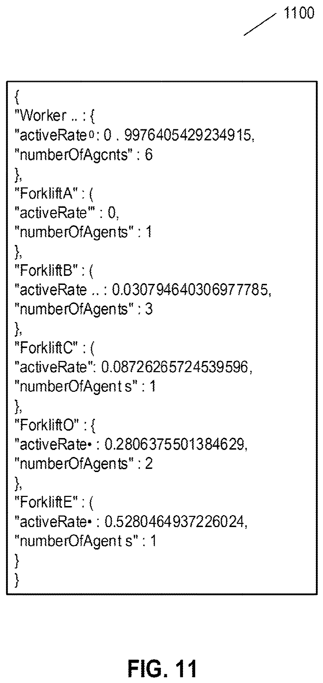

FIG. 11 illustrates an example output 1100 of calculated agents' activity rates, in accordance with an example implementation. Agents are active when they are processing a task, and considered inactive while waiting for tasks to be assigned. As illustrated in FIG. 11, "ForkliftA" is a single agent with an activity rate/active rate of "0," which indicates that it is inactive and waiting for tasks to be assigned.

The process then continues to step S1006 where visualization of the voxel-by-voxel actions of the agents is performed. The calculated overall throughputs, agents' activity rates, and the visualized actions of the agents are then outputted for review at step S1008.

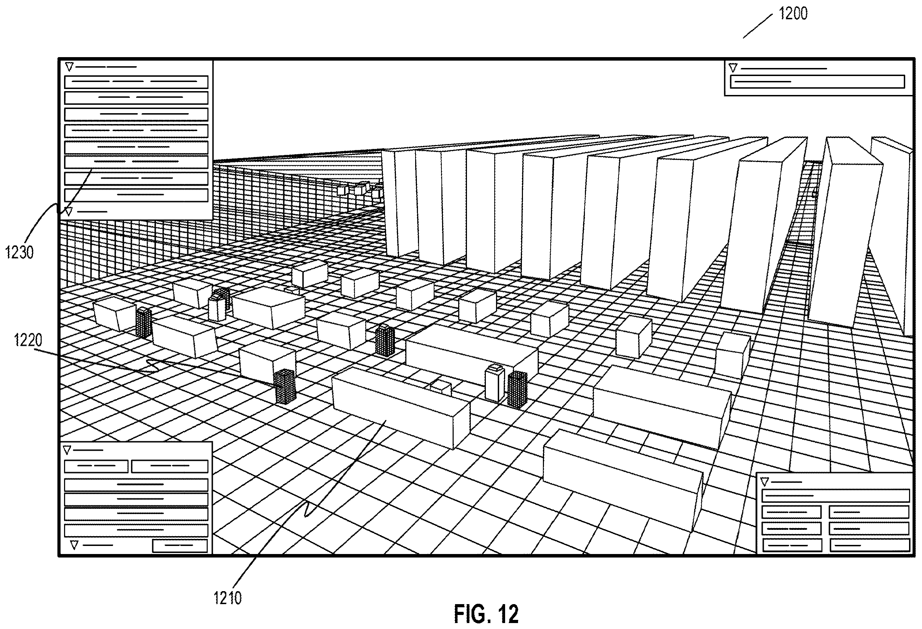

FIG. 12 illustrates an example output 1200 of the report generator 195, in accordance with an example implementation. As illustrated in FIG. 12, the output 1200 contains visualized simulation containing receptors 1210 and agents 1220. In addition to the visualized simulation, simulation results 1230 (e.g., simulation lead time, overview, etc.) may also be included as part of the output. The simulation results may indicate how long it took to complete all the tasks given in the input data. For visualization, the boxes representing agents can be replaced with 3D models of human workers, while the boxes representing receptors can be replaced with 3D models of shelves.

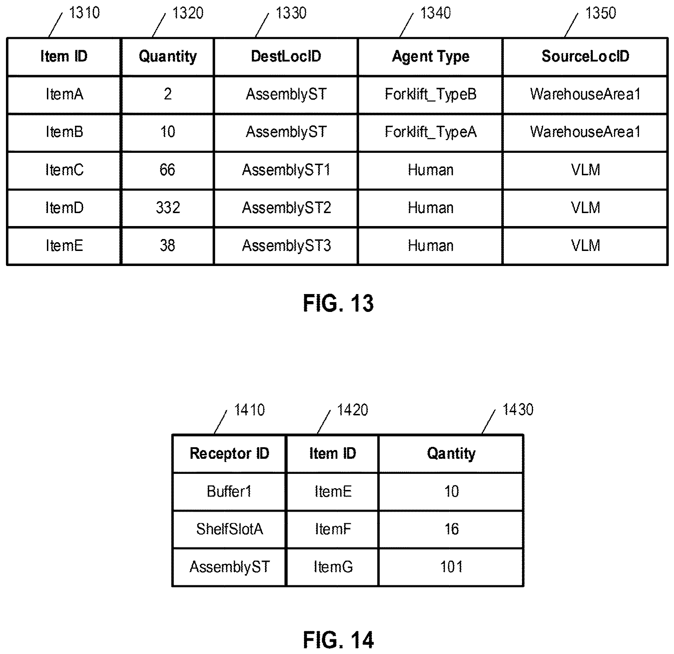

FIG. 13 illustrates example transportation orders 130b, in accordance with an example implementation. As illustrated in FIG. 13, transportation orders 130b may include information such as, but not limited to, Item ID 1310, Quantity 1320, DestLocID 1330, Agent Type 1340, SourceLocID 1350, etc. Item ID 1310 is a unique identification associated with an item/inventory in the simulation space. Quantity 1320 represents the number of available item/inventory. DestLocID 1330 identifies a destination receptor or a group of destination receptors where the items/inventories are to be transported to. Agent Type 1340 identifies the type of agents that are to handle the particular line of order. SourceLocID 1350 identifies a source location (e.g., source receptor or a group of source receptors) where the items/inventories are to be transported from.

FIG. 14 illustrates example transportation orders 130b, in accordance with an example implementation. As illustrated in FIG. 14, transportation orders 130b may include information such as, but not limited to, Receptor ID 1410, Item ID 1420, Quantity 1430, etc. Receptor ID 1410 represents an identifier of the receptor in the simulation space. Item ID 1420 is a unique ID of the item in the simulation space. Quantity 1430 represents the number of available item/inventory in the receptor.

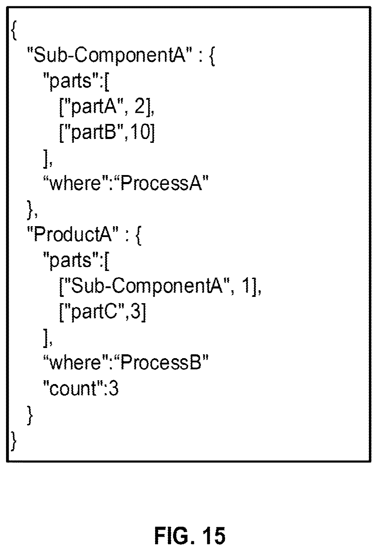

FIG. 15 illustrates example assembly orders 130c, in accordance with an example implementation. Assembly orders 130c may be represented in any known file format (e.g., JSON, etc.). As illustrated in FIG. 15, "Sub-ComponentA" is an ID of a subcomponent, which is assembled at "ProcessA" using two pieces of "partA" and ten pieces of "partB." "ProductA" is manufactured at "ProcessB" using a "Sub-ComponentA" and three pieces of "partC." These assembly orders require three of "ProductA" to be manufactured in the simulation.

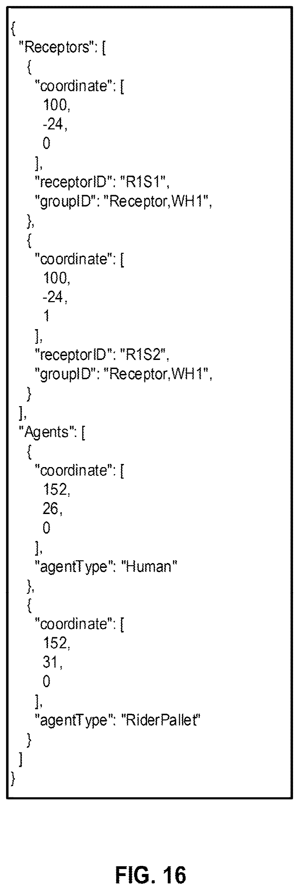

FIG. 16 illustrates example layout data 130a, in accordance with an example implementation. As with assembly orders 130c, the layout data 130a may be represented in any known file format (e.g., JSON, etc.). As illustrated in FIG. 16, the value of "Receptors" has a list that contains the elements of receptors. "coordinate" is the coordinate of the receptor. "receptorID" is the ID of the receptor. "groupID" is the group ID of the receptor. The value of "Agents" has a list that contains the elements of agents. "agentType" is the ID of agent types.

The foregoing example implementation may have various benefits and advantages, such as a unique way of representing industrial system as agents and receptors in voxel form through model simulation. By computing the simulation space as a voxel-by-voxel representation instead of a continuous space representation, which typically induces more computation to calculate the trajectories of agents and visualize the trajectory of agents, computational complexity can be drastically reduced. By simplifying the data structure and applying the simplified data structure as a unified representation of tasks, modeling burden and design expertise can be significantly reduced (e.g., design costs, graphic resources, etc.).

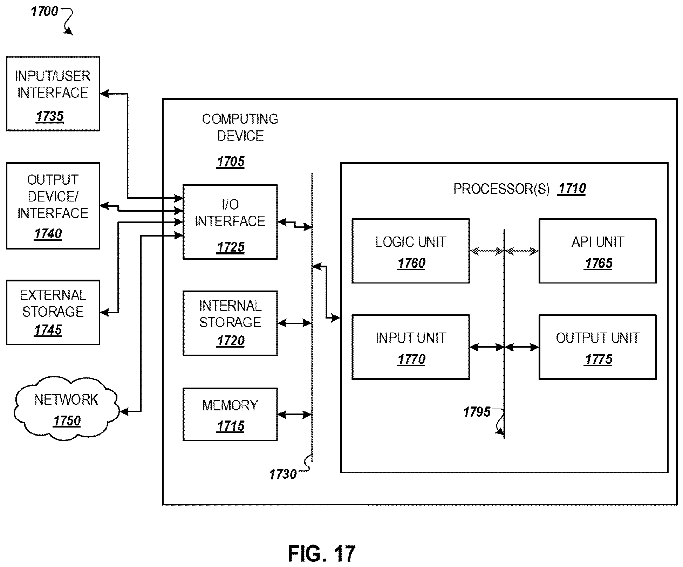

FIG. 17 illustrates an example computing environment with an example computer device suitable for use in some example implementations. Computer device 1705 in computing environment 1700 can include one or more processing units, cores, or processors 1710, memory 1715 (e.g., RAM, ROM, and/or the like), internal storage 1720 (e.g., magnetic, optical, solid-state storage, and/or organic), and/or IO interface 1725, any of which can be coupled on a communication mechanism or bus 1730 for communicating information or embedded in the computer device 1705. IO interface 1725 is also configured to receive images from cameras or provide images to projectors or displays, depending on the desired implementation.

Computer device 1705 can be communicatively coupled to input/user interface 1735 and output device/interface 1740. Either one or both of the input/user interface 1735 and output device/interface 1740 can be a wired or wireless interface and can be detachable. Input/user interface 1735 may include any device, component, sensor, or interface, physical or virtual, that can be used to provide input (e.g., buttons, touch-screen interface, keyboard, a pointing/cursor control, microphone, camera, braille, motion sensor, accelerometer, optical reader, and/or the like). Output device/interface 1740 may include a display, television, monitor, printer, speaker, braille, or the like. In some example implementations, input/user interface 1735 and output device/interface 1740 can be embedded with or physically coupled to the computer device 1705. In other example implementations, other computer devices may function as or provide the functions of input/user interface 1735 and output device/interface 1740 for a computer device 1705.

Examples of computer device 1705 may include, but are not limited to, highly mobile devices (e.g., smartphones, devices in vehicles and other machines, devices carried by humans and animals, and the like), mobile devices (e.g., tablets, notebooks, laptops, personal computers, portable televisions, radios, and the like), and devices not designed for mobility (e.g., desktop computers, other computers, information kiosks, televisions with one or more processors embedded therein and/or coupled thereto, radios, and the like).

Computer device 1705 can be communicatively coupled (e.g., via IO interface 1725) to external storage 1745 and network 1750 for communicating with any number of networked components, devices, and systems, including one or more computer devices of the same or different configuration. Computer device 1705 or any connected computer device can be functioning as, providing services of, or referred to as a server, client, thin server, general machine, special-purpose machine, or another label.

IO interface 1725 can include but is not limited to, wired and/or wireless interfaces using any communication or IO protocols or standards (e.g., Ethernet, 802.11x, Universal System Bus, WiMax, modem, a cellular network protocol, and the like) for communicating information to and/or from at least all the connected components, devices, and network in computing environment 1700. Network 1750 can be any network or combination of networks (e.g., the Internet, local area network, wide area network, a telephonic network, a cellular network, satellite network, and the like).

Computer device 1705 can use and/or communicate using computer-usable or computer readable media, including transitory media and non-transitory media. Transitory media include transmission media (e.g., metal cables, fiber optics), signals, carrier waves, and the like. Non-transitory media include magnetic media (e.g., disks and tapes), optical media (e.g., CD ROM, digital video disks, Blu-ray disks), solid-state media (e.g., RAM, ROM, flash memory, solid-state storage), and other non-volatile storage or memory.

Computer device 1705 can be used to implement techniques, methods, applications, processes, or computer-executable instructions in some example computing environments. Computer-executable instructions can be retrieved from transitory media, and stored on and retrieved from non-transitory media. The executable instructions can originate from one or more of any programming, scripting, and machine languages (e.g., C, C++, C#, Java, Visual Basic, Python, Perl, JavaScript, and others).

Processor(s) 1710 can execute under any operating system (OS) (not shown), in a native or virtual environment. One or more applications can be deployed that include logic unit 1760, application programming interface (API) unit 1765, input unit 1770, output unit 1775, and inter-unit communication mechanism 1795 for the different units to communicate with each other, with the OS, and with other applications (not shown). The described units and elements can be varied in design, function, configuration, or implementation and are not limited to the descriptions provided. Processor(s) 1710 can be in the form of hardware processors such as central processing units (CPUs) or in a combination of hardware and software units.

In some example implementations, when information or an execution instruction is received by API unit 1765, it may be communicated to one or more other units (e.g., logic unit 1760, input unit 1770, output unit 1775). In some instances, logic unit 1760 may be configured to control the information flow among the units and direct the services provided by API unit 1765, the input unit 1770, the output unit 1775, in some example implementations described above. For example, the flow of one or more processes or implementations may be controlled by logic unit 1760 alone or in conjunction with API unit 1765. The input unit 1770 may be configured to obtain input for the calculations described in the example implementations, and the output unit 1775 may be configured to provide an output based on the calculations described in example implementations.

Processor(s) 1710 can be configured to receive input data for generating a simulation model and storing the input data in the data storage as shown in FIGS. 1 and 3. The processor(s) 1710 may also be configured to generate the simulation model for performing simulations based on the input data, the simulation model comprises a voxel model that performs simulations as voxel-by-voxel representations as shown in FIGS. 1 and 3. The processor(s) 1710 may also be configured to generate a simulation report based on simulation output of the simulation model as shown in FIGS. 1 and 3.

The processor(s) 1710 may also be configured to perform model simulation initialization as shown in FIGS. 1 and 3. The processor(s) 1710 may also be configured to perform event simulations as shown in FIGS. 1 and 3.

The processor(s) 1710 may also be configured to load the input data as shown in FIGS. 1 and 3-4. The processor(s) 1710 may also be configured to initialize a simulation timer and an event list as shown in FIGS. 1 and 3-4.

The processor(s) 1710 may also be configured to generate events to be added to the event list based on the input data and adding the events to the event list as shown in FIGS. 1 and 3. The processor(s) 1710 may also be configured to perform the event simulations based on the events contained in the event list as shown in FIGS. 1 and 3.

The processor(s) 1710 may also be configured to verify parts required for performing one or more assemblies contained in the assembly order information by cross-referencing the inventory data as shown in FIGS. 1, 3, and 6-7. The processor(s) 1710 may also be configured to generate a transportation order for each of the one or more assemblies where parts required have been successfully verified as shown in FIGS. 1, 3, and 6-7.

The processor(s) 1710 may also be configured to generate one or more transportation events that correspond to one or more transportation orders as shown in FIGS. 1, 3, and 6-7. The processor(s) 1710 may also be configured to generate one or more assembly events that correspond to one or more assemblies where parts required have been successfully verified as shown in FIGS. 1, 3, and 6-7. The processor(s) 1710 may also be configured to add the one or more transportation events and the one or more assembly events to the event list as shown in FIGS. 1, 3, and 6-7.

The processor(s) 1710 may also be configured to extract the one or more transportation events and the one or more assembly events from the event list as shown in FIGS. 1, 3, and 6-7. The processor(s) 1710 may also be configured to perform simulations based on the one or more transportation events and the one or more assembly events as shown in FIGS. 1, 3, and 6-7.

The processor(s) 1710 may also be configured to identify a simulation termination condition for stopping the simulations as shown in FIGS. 1, 3, and 8-9. The processor(s) 1710 may also be configured to determine whether the simulation termination condition has been satisfied as shown in FIGS. 1, 3, and 8-9. The processor(s) 1710 may also be configured to, for the simulation termination condition being determined as satisfied, terminate the simulations as shown in FIGS. 1, 3, and 8-9. The processor(s) 1710 may also be configured to, for the simulation termination condition not determined as satisfied, continue to perform the simulations until the simulation termination condition is met as shown in FIGS. 1, 3, and 8-9.

Some portions of the detailed description are presented in terms of algorithms and symbolic representations of operations within a computer. These algorithmic descriptions and symbolic representations are the means used by those skilled in the data processing arts to convey the essence of their innovations to others skilled in the art. An algorithm is a series of defined steps leading to a desired end state or result. In example implementations, the steps carried out require physical manipulations of tangible quantities for achieving a tangible result.

Unless specifically stated otherwise, as apparent from the discussion, it is appreciated that throughout the description, discussions utilizing terms such as "processing," "computing," "calculating," "determining," "displaying," or the like, can include the actions and processes of a computer system or other information processing device that manipulates and transforms data represented as physical (electronic) quantities within the computer system's registers and memories into other data similarly represented as physical quantities within the computer system's memories or registers or other information storage, transmission or display devices.

Example implementations may also relate to an apparatus for performing the operations herein. This apparatus may be specially constructed for the required purposes, or it may include one or more general-purpose computers selectively activated or reconfigured by one or more computer programs. Such computer programs may be stored in a computer readable medium, such as a computer readable storage medium or a computer readable signal medium. A computer readable storage medium may involve tangible mediums such as, but not limited to, optical disks, magnetic disks, read-only memories, random access memories, solid-state devices, and drives, or any other types of tangible or non-transitory media suitable for storing electronic information. A computer readable signal medium may include mediums such as carrier waves. The algorithms and displays presented herein are not inherently related to any particular computer or other apparatus. Computer programs can involve pure software implementations that involve instructions that perform the operations of the desired implementation.

Various general-purpose systems may be used with programs and modules in accordance with the examples herein, or it may prove convenient to construct a more specialized apparatus to perform the desired method steps. In addition, the example implementations are not described with reference to any particular programming language. It will be appreciated that a variety of programming languages may be used to implement the teachings of the example implementations as described herein. The instructions of the programming language(s) may be executed by one or more processing devices, e.g., central processing units (CPUs), processors, or controllers.

As is known in the art, the operations described above can be performed by hardware, software, or some combination of software and hardware. Various aspects of the example implementations may be implemented using circuits and logic devices (hardware), while other aspects may be implemented using instructions stored on a machine-readable medium (software), which if executed by a processor, would cause the processor to perform a method to carry out implementations of the present application. Further, some example implementations of the present application may be performed solely in hardware, whereas other example implementations may be performed solely in software. Moreover, the various functions described can be performed in a single unit, or can be spread across a number of components in any number of ways. When performed by software, the methods may be executed by a processor, such as a general-purpose computer, based on instructions stored on a computer readable medium. If desired, the instructions can be stored on the medium in a compressed and/or encrypted format.

Moreover, other implementations of the present application will be apparent to those skilled in the art from consideration of the specification and practice of the teachings of the present application. Various aspects and/or components of the described example implementations may be used singly or in any combination. It is intended that the specification and example implementations be considered as examples only, with the true scope and spirit of the present application being indicated by the following claims.

## Claims

1. A method for performing system simulations, the method comprising:
receiving, by a processor, input data for generating a simulation model;
generating, by the processor, the simulation model for performing simulations based on the input data, the simulation model comprises a voxel model that performs simulations as voxel-by-voxel representations; and
generating, by the processor, a simulation report based on simulation output of the simulation model.

2. The method of claim 1, wherein each of the voxel-by-voxel representations comprise one or more agents and one or more receptors in voxel form across a plurality of grids.

3. The method of claim 1, wherein the simulations are performed by:
performing model simulation initialization; and
performing event simulations.

4. The method of claim 3, wherein the performing the model simulation initialization comprises:
loading the input data; and
initializing a simulation timer and an event list,
wherein the input data comprises system layout data, assembly order information, and inventory data.

5. The method of claim 4, wherein the performing the event simulations comprises:
generating events to be added to the event list based on the input data and adding the events to the event list; and
performing the event simulations based on the events contained in the event list.

6. The method of claim 5, wherein the generating the events to be added to the event list comprises:
verifying parts required for performing one or more assemblies contained in the assembly order information by cross-referencing the inventory data; and
generating a transportation order for each of the one or more assemblies where parts required have been successfully verified.

7. The method of claim 5, further comprising:
generating, by the processor, one or more transportation events that correspond to one or more transportation order;
generating, by the processor, one or more assembly events that correspond to one or more assemblies where parts required have been successfully verified; and
adding, by the processor, the one or more transportation events and the one or more assembly events to the event list.

8. The method of claim 7, wherein the performing the event simulations comprises:
extracting the one or more transportation events and the one or more assembly events from the event list; and
performing simulations based on the one or more transportation events and the one or more assembly events.

9. The method of claim 1, further comprising:
identifying, by the processor, a simulation termination condition for stopping the simulations;
determining, by the processor, whether the simulation termination condition has been satisfied;
for the simulation termination condition being determined as satisfied, terminating, by the processor, the simulations; and
for the simulation termination condition not determined as satisfied, continuing, by the processor, the simulations until the simulation termination condition is met.

10. The method of claim 1, wherein the simulation report comprises a voxel-based visualization and a plurality of Key Performing Indicators (KPI) derived based on the simulations.

11. A system for performing system simulations, the system comprising:
a data storage; and
a processor in communication with the data storage, wherein the processor is configured to:
receive input data for generating a simulation model and storing the input data in the data storage;
generate the simulation model for performing simulations based on the input data, the simulation model comprises a voxel model that performs simulations as voxel-by-voxel representations; and
generate a simulation report based on simulation output of the simulation model.

12. The system of claim 11, wherein each of the voxel-by-voxel representations comprise one or more agents and one or more receptors in voxel form across a plurality of grids.

13. The system of claim 11, wherein the simulations are performed by:
performing model simulation initialization; and
performing event simulations.

14. The system of claim 13, wherein the perform the model simulation initialization comprises:
loading the input data; and
initializing a simulation timer and an event list,
wherein the input data comprises system layout data, assembly order information, and inventory data.

15. The system of claim 14, wherein the perform the event simulations comprises:
generating events to be added to the event list based on the input data and adding the events to the event list; and
performing the event simulations based on the events contained in the event list.

16. The system of claim 15, wherein the generate the events to be added to the event list comprises:
verifying parts required for performing one or more assemblies contained in the assembly order information by cross-referencing the inventory data; and
generating a transportation order for each of the one or more assemblies where parts required have been successfully verified.

17. The system of claim 15, wherein the processor is further configured to:
generate one or more transportation events that correspond to one or more transportation order;
generate one or more assembly events that correspond to one or more assemblies where parts required have been successfully verified; and
add the one or more transportation events and the one or more assembly events to the event list.

18. The system of claim 17, wherein the perform the event simulations comprises:
extracting the one or more transportation events and the one or more assembly events from the event list; and
performing simulations based on the one or more transportation events and the one or more assembly events.

19. The system of claim 11, wherein the processor is further configured to:
identify a simulation termination condition for stopping the simulations;
determine whether the simulation termination condition has been satisfied;
for the simulation termination condition being determined as satisfied, terminate the simulations; and
for the simulation termination condition not determined as satisfied, continue to perform the simulations until the simulation termination condition is met.

20. The system of claim 11, wherein the simulation report comprises a voxel-based visualization and a plurality of Key Performing Indicators (KPI) derived based on the simulations.
